# EUROPEAN PATENT APPLICATION

(11) **EP 3 723 286 A1**
(43) Date of publication of application: **14.10.2020**
(21) Application number: 19168644.3
(22) Date of filing: 11.04.2019
(51) Int. Cl.: H03K 17/0412, H03K 17/0812, B06B 1/02

(54) **ULTRASOUND TRANSDUCER HALF-BRIDGE DRIVER CIRCUIT**

(71) Applicant: Koninklijke Philips N.V., 5656 AG Eindhoven (NL)
(72) Inventor: BLANKEN, Pieter Gerrit, 5656 AE Eindhoven (NL)
(74) Representative: de Haan, Poul Erik

(57) **Abstract**

An ultrasound transducer driver circuit UTDC includes a half-bridge output stage and a level-shifter. The half-bridge output stage includes a high-side transistor MP0, a low-side transistor MN0. The high-side transistor MP0 comprises a p-channel FET and the low-side transistor MN0 comprises an n-channel FET. A pullup component R1 of the level shifter includes a voltage-limiting component or circuit Zl, D₁..Dₙ, Ql, Rla, R1b, MNclamp that conducts a portion of the current provided by a first current source MN1 of the level shifter to limit the gate-source voltage of the p-channel FET MP0 to less than a gate-source breakdown voltage of the p-channel FET MP0.

## Description

### FIELD OF THE INVENTION

The invention relates to an ultrasound transducer driver circuit. The circuit may be used in a variety of ultrasound imaging, sensing and measurement systems including medical ultrasound imaging systems. Its use in both 2D and 3D ultrasound imaging systems is contemplated. The circuit may for example be used in intravascular "IVUS" ultrasound imaging systems, as well as in transesophageal "TEE", transthoracic "TTE", transnasal "TNE", intracardiac "ICE", and transrectal "TRUS", ultrasound imaging systems. The ultrasound transducer driver circuit is contemplated for use in driving ultrasound transducers in general, and may exemplarily be used to drive a capacitive micromachined ultrasound transducer "CMUT", or a piezoelectric ultrasound transducer.

### BACKGROUND OF THE INVENTION

Various ultrasound transducer driver circuits have been developed in order to address the combined demands of low power consumption and fast switching and at the high switching voltages encountered in ultrasound imaging, sensing and measurement applications. These challenging demands are further compounded by the tight space constraints and long cable lengths encountered in the exemplary application area of IVUS imaging. The ultrasound transducers used in such applications typically require voltages that are in the order of a few tens of volts to be switched within a period of from a few nanoseconds to a few microseconds. Often a combination of so-called high-voltage FETs, defined herein as having a drain-source breakdown voltage exceeding its gate-source breakdown voltage, and so-called low-voltage FETs, defined herein as having a drain-source breakdown voltage that is less than or equal to its gate-source breakdown voltage; integrated circuit, IC, technologies are used to fabricate the transistors used in the respective driving and control portions of these circuits. By today's integrated-circuit standards a high-voltage FET or bipolar transistor typically has an operational voltage that exceeds 3.3 Volts, and a low-voltage FET or bipolar transistor typically has an operational voltage that is less than or equal to 3.3 Volts.

One type of driver circuit used in switching voltages of a few tens of volts includes a so-called half-bridge output stage. A half-bridge output stage includes a high-side transistor and a low-side transistor coupled between two power rails. The high-side transistor is coupled to a first power rail that supplies a first voltage, and the low-side transistor is coupled to a second power rail that supplies a second voltage, the second voltage being relatively lower than the first voltage. A common connection between the two transistors serves as an output terminal and is connected to a first electrode of a load. A second electrode of the load is connected to a bias voltage or zero volts. By alternately switching the high-side and low-side transistor between the conducting and non-conducting states such that they are in opposite states, a voltage on the first electrode is modulated between the first voltage and the second voltage.

In this respect a document by Eric J. Wildi, John P. Walden, Michael S. Adler entitled "A 500V/25A half-bridge IC with on-chip control logic", Digest of Technical Papers of the 28th IEEE International Solid-State Circuits Conference ISSCC1985, New York, USA, Feb. 1985, pp. 266 - 267 discloses a driver circuit that includes a half-bridge output stage.

A half-bridge output stage is also known from US patent US 4,994,955.

In spite of these developments there remains room to provide an improved circuit for driving an ultrasound transducer.

### SUMMARY OF THE INVENTION

The invention seeks to provide an improved circuit for driving an ultrasound transducer. Thereto, an ultrasound transducer driver circuit is provided as defined in claim 1. An application specific integrated circuit, and an ultrasound imaging system that incorporate the ultrasound transducer driver circuit are also provided.

The ultrasound transducer driver circuit includes a half-bridge output stage and a level-shifter. The half-bridge output stage includes a high-side transistor, a low-side transistor, and an output terminal for driving an ultrasound transducer. The high-side transistor comprises a p-channel FET and the low-side transistor comprises an n-channel FET. The level-shifter comprises a first current source and a pullup component configured to modulate a voltage applied to a control input of the high-side transistor by alternately switching a current provided by the first current source between a first magnitude and a second magnitude such that a potential difference generated across the pullup component causes the high-side transistor to be switched respectively between a non-conducting state and a conducting state by controlling a gate-source voltage of the p-channel FET.

The inventor has found that a drawback of a conventional half-bridge output stage that is driven by level shifter that includes a current source and a pullup component, is a slow switching speed of the output terminal of the half-bridge output stage whilst it undergoes a positive voltage transition. This positive voltage transition occurs when the high-side transistor is switched into the conducting state and is initiated by the first current source providing the current with the second magnitude. The current with the second magnitude generates a potential difference across the pullup component, causing the high-side transistor to be switched into the conducting state. When the high-side transistor is a p-channel FET, during this positive voltage transition the high-side transistor's parasitic drain-gate capacitance couples charge between the output terminal, which is coupled to the drain, and the gate. This coupled charge gives rise to a gate current that causes the potential difference generated across the pullup component to reduce. This reduces the gate-source voltage of the high-side transistor. As a consequence the magnitude of the drain-source current in the high-side transistor decreases and the slope of the positive voltage transition also decreases, giving rise to the slow switching speed.

In accordance with the principles of a first embodiment the pullup component in the level shifter includes a voltage-limiting component or circuit configured to conduct a portion of the current provided by the first current source when said current has the second magnitude and thereby limit the gate-source voltage of the p-channel FET to less than a gate-source breakdown voltage of the p-channel FET. This permits the second magnitude of the current to be set at a higher level than would be possible in the absence of the voltage-limiting component or circuit. The second magnitude of the current may therefore be set at a level that compensates for the gate or base current during the positive voltage transition at output terminal Tout. It may even be set at such a level that would, in the absence of the voltage-limiting component or circuit, damage the high-side transistor. When the voltage-limiting component or circuit conducts a portion of this second magnitude current, it limits the gate-source voltage, such that the high-side transistor is not damaged. Thus, the high-side transistor may be driven harder than would be possible without the voltage-limiting component or circuit, and without risk of damaging it. In so doing the switching speed at the output terminal is increased whilst it undergoes a positive voltage transition.

In accordance with a second embodiment the first current source is instead configured to reduce the current from the second magnitude to a third magnitude after the high-side transistor is switched into the conducting state for maintaining the high-side transistor in the conducting state and ensuring the potential difference generated across the pullup component is less than a gate-source breakdown voltage of the p-channel FET. In so doing the switching speed at the output terminal may be set to an elevated value whilst it undergoes a positive voltage transition, and by reducing this value after the transition, damage to the high-side transistor may be prevented.

In accordance with a third embodiment the level-shifter instead comprises a compensation current source configured to adjust the potential difference generated across the pullup component during a switching transition at the output terminal whilst the high-side transistor is switched between the non-conducting state and the conducting state for compensating for a change in voltage at the control input during said switching transition. In so doing the switching speed at the output terminal is increased whilst it undergoes a positive voltage transition. The compensation current source may for example be coupled in series with the first current source; and further include a sense capacitor and a feed-forward circuit that senses the switching transition at the output terminal and in response to the switching transition controls a current provided by the compensation current source to thereby control the potential difference generated across the pullup component for compensating for the change in voltage at the control input during the switching transition.

Further aspects and their advantages are described with reference to the appended claims.

### BRIEF DESCRIPTION OF THE FIGURES

Fig. 1 illustrates an ultrasound transducer driver circuit UTDC that includes a half-bridge output stage MP0, MN0, a level shifter MN1, R1, and an output terminal Tout.
Fig. 2 illustrates various currents in the ultrasound transducer driver circuit of Fig. 1.
Fig. 3 illustrates various signals in the circuit of Fig. 2.
Fig. 4 illustrates an ultrasound transducer driver circuit UTDC that includes a voltage-limiting component Z1.
Fig. 5 illustrates various signals in the circuit of Fig. 4.
Fig. 6 illustrates an ultrasound transducer driver circuit UTDC that includes a voltage-limiting component Z1 and an optional second current source I_{SMN1}.
Fig. 7 illustrates an ultrasound transducer driver circuit UTDC that includes voltage-limiting component(s) D₁..Dₙ and an optional second current source I_{SMN1}.
Fig. 8 illustrates an ultrasound transducer driver circuit UTDC that includes a voltage-limiting circuit Q1, R1a, R1b and an optional second current source I_{SMN1}.
Fig. 9 illustrates an ultrasound transducer driver circuit UTDC that includes a voltage-limiting component MNclamp and an optional second current source I_{SMN1}.
Fig. 10 illustrates various timing signals that may be used in accordance with a second embodiment in the circuit of Fig. 1 or Figs. 6 - 9.
Fig. 11 illustrates an ultrasound transducer driver circuit UTDC that includes a compensation current source Is_{MN2}, a sense capacitor Csense and a feed-forward circuit in accordance with a third embodiment.

### DETAILED DESCRIPTION OF THE INVENTION

In order to illustrate the principles of the present invention an ultrasound transducer driver circuit is described with reference to the exemplary application of driving a CMUT transducer in an IVUS imaging system. It is however to be understood that the ultrasound transducer driver circuit finds application in the ultrasound imaging field in general and is not limited to this exemplary use. Use of the ultrasound transducer driver circuit is contemplated in a variety of ultrasound imaging, sensing and measurement systems including medical ultrasound imaging systems. Its use in both 2D and 3D ultrasound imaging systems is contemplated. The circuit may for example be used in intravascular "IVUS" ultrasound imaging systems, as well as in transesophageal "TEE", transthoracic "TTE", transnasal "TNE", intracardiac "ICE", and transrectal "TRUS", ultrasound imaging systems. The ultrasound transducer driver circuit is contemplated for use in driving ultrasound transducers in general, and may exemplarily be used to drive a capacitive micromachined ultrasound transducer "CMUT", or a piezoelectric ultrasound transducer, or indeed ultrasound transducers formed from other materials.

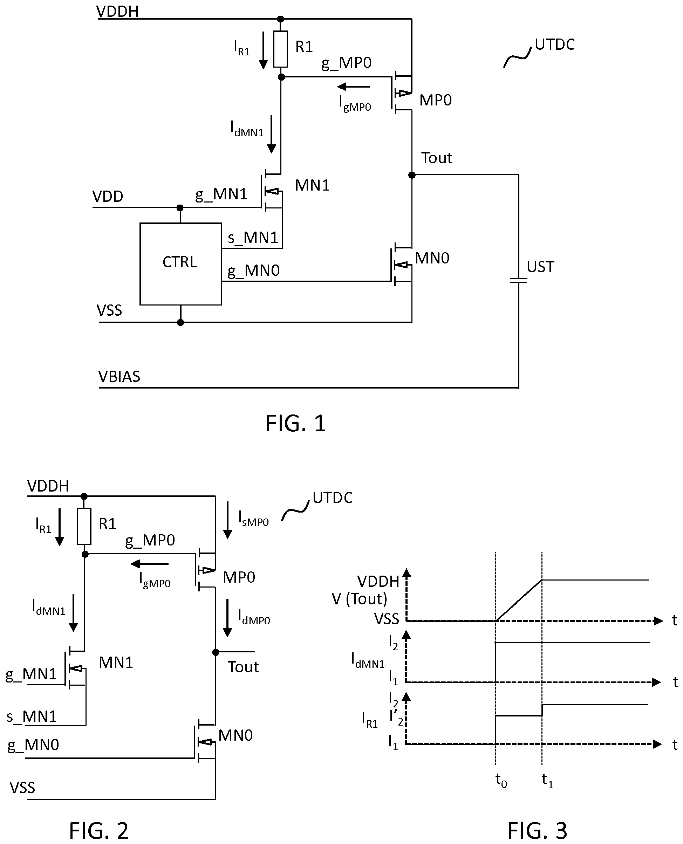

Fig. 1 illustrates an ultrasound transducer driver circuit UTDC that includes a half-bridge output stage MP0, MN0, a level shifter MN1, R1, and an output terminal Tout. Ultrasound transducer driver circuit UTDC may be used, as illustrated, to drive optional ultrasound transducer UST, which may for example be a CMUT transducer forming part of an array of such transducers within an IVUS imaging system. Half-bridge output stage MP0, MN0 includes high-side output transistor MP0 and low-side output transistor MN0 that are coupled in series between first power rail VDDH and second power rail VSS. More specifically a p-channel FET serves as high-side transistor MP0 and an n-channel FET serves as low-side transistor MN0, a source of high-side transistor MP0 may be coupled to first power rail VDDH and a source of low-side transistor MN0 may be coupled to second power rail VSS. First power rail VDDH may supply a first voltage, and second power rail VSS may supply a second voltage, the first voltage being relatively higher than the second voltage. The first voltage may be approximately 30 - 40 Volts and the second voltage may be approximately 0 Volts. These values are however purely exemplary. A common connection between high-side transistor MP0 and low-side transistor MN0, more specifically a drain of each FET serves as output terminal Tout, which may be used to drive optional ultrasound transducer UST.

Where (MOS)FETs are illustrated and referred-to in this disclosure, it is preferred that so-called enhancement devices are used.

In-use the half-bridge output stage may be operated such that output terminal Tout, and thus a first electrode of optional ultrasound transducer UST, is alternately coupled to each of first power rail VDDH and second power rail VSS by applying a voltage to a control input, specifically a gate, or a base, of each of high-side transistor MP0 and low-side transistor MN0, i.e. g_MP0 and g_MN0 in Fig. 1. When high-side transistor MP0 is a p-channel enhancement (MOS)FET and low-side transistor MN0 is an n-channel enhancement (MOS)FET, either transistor may be switched on, i.e. into the conducting state, by providing the respective transistor with a gate-source voltage that exceeds its gate-source threshold voltage. Control inputs g_MP0 and g_MN0 may thus be used to alternately switch each of low-side transistor MN0 and high-side transistor MP0 into each of the conducting state and the non-conducting state such that low-side transistor MN0 and high-side transistor MP0 are in opposite states. In so doing, output terminal Tout and thus the first electrode of optional ultrasound transducer UST may be alternately coupled to each of first power rail VDDH and second power rail VSS. A second electrode of optional ultrasound transducer UST is coupled to power rail VBIAS in Fig. 1. Power rail VBIAS may supply a third voltage, which in one example may be approximately -50 Volts. Other bias voltages, positive and negative, and also 0 Volts, may alternatively be used. In so doing, by alternately coupling output terminal Tout to each of first power rail VDDH and second power rail VSS, a potential difference voltage across ultrasound transducer UST is modulated between two voltage levels: VDDH-VBIAS, and VSS-VBIAS.

In a preferred configuration, high-side transistor MP0 and low-side transistor MN0 each comprise a so-called high-voltage transistor. One exemplary chip technology that may be used to fabricate high-voltage transistors is ONC18 with the I4T 45V option. High-voltage transistors may be used to withstand the voltages that are applied across the electrodes of ultrasound transducer UST in the contemplated application of IVUS imaging. In this respect, it may be necessary to switch a voltage of a few tens of volts, typically between 50 Volts and 80 - 90 Volts, across ultrasound transducer UST.

In order to switch such voltages, a level-shifter is typically used to switch the control input of high-side transistor MP0. With reference to Fig. 1, if purely for example, VDDH = 40 Volts, VSS = 0 Volts and the absolute value of the threshold voltage of each of high-side transistor MP0 and low-side transistor MN0, is 1 Volt, high-side transistor MP0 requires a voltage at its control input g_MP0 to be modulated between approximately that of the first power rail, i.e. VDDH at approximately 40 Volts, and 36.9 Volts in order to switch it between the non-conducting state and the conducting state.

With reference to Fig. 1, a level-shifter is provided by first current source MN1 and pullup component R1 for switching high-side transistor MP0 between a conducting state and a non-conducting state by controlling a gate-source voltage of p-channel FET MP0. First current source MN1 and pullup component R1 are arranged in Fig. 1 to modulate a voltage applied to a control input g_MP0 of high-side transistor MP0 by alternately switching a current provided by first current source MN1 between a first magnitude I₁ and a second magnitude I₂ such that a potential difference generated across pullup component R1 causes high-side transistor MP0 to be switched respectively between a non-conducting state and a conducting state by controlling a gate-source voltage of the p-channel FET MP0. First pullup component R1 is illustrated as being a resistor, although this may alternatively be implemented by means of e.g. FET or bipolar transistor operated as a resistor. The first magnitude I₁ may exemplarily be zero or negligible. When the current provided by the first current source MN1 has the first magnitude I₁, pullup component R1 couples the gate g_MP0 of p-channel FET MP0 to its source, which generates a sub-threshold gate-source voltage for high-side transistor MP0, causing high-side transistor MP0 to be switched into the non-conducting state. The second magnitude I₂ may in contrast be a non-zero value that generates an above-threshold gate-source voltage for p-channel FET MP0, causing high-side transistor MP0 to be switched into the conducting state.

By contrast the control of low-side transistor MN0 in the configuration of Fig. 1 is less complex than that of high-side transistor MP0 because its source is referenced to second power rail VSS. A gate-source threshold voltage of low-side transistor MN0 may for example be 0.7 Volts. A voltage at its control input g_MN0 may exemplarily be modulated between a voltage that is less than its gate-source threshold voltage, for example the voltage of the second power rail VSS, i.e. approximately 0V, and a voltage that exceeds its gate-source threshold voltage, for example the value of VDD, for example 3.1 Volts, in order to switch low-side transistor MN0 between the non-conducting state and the conducting state. Switching this, relatively lower voltage, can typically be achieved in the absence of a level-shifter and is therefore less complex than controlling high-side transistor MP0 since typically no level shifter is required.

Drawbacks of using so-called high-voltage transistors as high-side transistor MP0 and low-side transistor MN0, typically include their large size and large parasitic capacitances, the latter typically giving rise to reduced switching speeds as compared to transistors that operate at lower voltages. The thin gate oxide used in these devices may also limit the maximum gate-source voltages that may be applied to these devices without damaging the transistor.

Fig. 2 illustrates various currents in the ultrasound transducer driver circuit of Fig. 1. Fig. 3 illustrates various signals in the circuit of Fig. 2. A drawback of the circuit of Fig. 1 is now highlighted with reference to Fig. 2 and Fig. 3 when the current provided by first current source MN1 is switched between the first value I₁ and the second value I₂, and thus whilst output terminal Tout undergoes a positive voltage transition. With reference to Fig. 3, when the current I_{dMN1} that is provided by first current source MN1 has the first value I₁, which is preferably a negligible value, i.e. at time 0 < t < to when I_{dMN1} = I₁ in Fig. 3, pullup component R1 couples the gate g_MP0 of high-side transistor, specifically p-channel FET MP0, to its source. The resulting gate-source voltage of p-channel FET MP0 is below its threshold voltage and thus high-side transistor MP0 is in the non-conducting state. Simultaneously, gate g_MN0 of low-side transistor MN0, specifically an n-channel FET, is held at a voltage such that an above-threshold gate-source voltage is applied to low-side transistor MN0 and thus low-side transistor MN0 is in the conducting state. Consequently output terminal Tout is coupled to power rail VSS for time 0 < t < t₀ and the voltage at output terminal Tout, i.e. V(Tout) in Fig. 3, is held at the voltage of power rail VSS.

In order to generate a positive output voltage pulse at terminal Tout, the current I_{dMN1} that is provided by first current source MN1 is increased to value I₂ at time t = t₀ such that I₂ × R1 > V_{thresholdMP0} wherein V_{thresholdMP0} is the absolute value of the gate-source threshold voltage of high-side transistor MP0, and simultaneously the gate g_MN0 of low-side transistor MN0 is held at a voltage such that a sub-threshold gate-source voltage is applied to low-side transistor MN0 and low-side transistor MN0 is in the non-conducting state.

Owing, in-part, to the parasitic drain-gate capacitance of high-side transistor MP0, when the voltage at output terminal Tout, i.e. V(Tout) starts to increase, i.e. for t₀ < t < t₁ in Fig. 3, charge is coupled between output terminal Tout and gate g_MP0. This coupled charge is represented by gate current I_{gMP0} in Fig. 2 and flows via pullup component R1 to power rail VDDH. For simplicity of explanation the parasitic drain-gate capacitance is assumed to be linear and voltage-independent in the graph of Fig. 3. The resulting gate current is constant when the rate-of-change dV(Tout)/dt of the output node Tout is constant. In practice the parasitic drain-gate capacitance will vary depending on the actual drain-gate voltage and thus some deviation from the waveforms in Fig. 3 can be expected. Gate current I_{gMP0} opposes current I_{R1} in pullup component R1, and consequently current I_{R1} in pullup component R1 has a value, I'₂, which is lower than the (desired) value provided by first current source MN1, i.e. it is lower than magnitude I₂. Consequently the potential difference across pullup component R1 is lower than its desired above-threshold value during the period t₀ < t < t₁. Thus, the gate-source voltage that has been applied to high-side transistor MP0 to switch it into the conducting state is lower than its desired value during the period t₀ < t < t₁. Consequently the magnitude of the drain-source current in high-side transistor MP0 is also lower than desired, and thus the slope of the positive voltage transition decreases, as seen in the slope of signal V(Tout) in Fig. 3 during time period t₀ < t < t₁. In short, the parasitic drain-gate capacitance of high-side transistor MP0 gives rise to a slow switching speed during a positive voltage transition at output terminal Tout. At the end of the positive voltage transition at output terminal Tout, i.e. for time t > t₁ in Fig. 3 the gate current I_{gMP0} becomes negligible and the current flowing in pullup component R1 becomes equal to the current provided by first current source MN1, specifically second magnitude I₂.

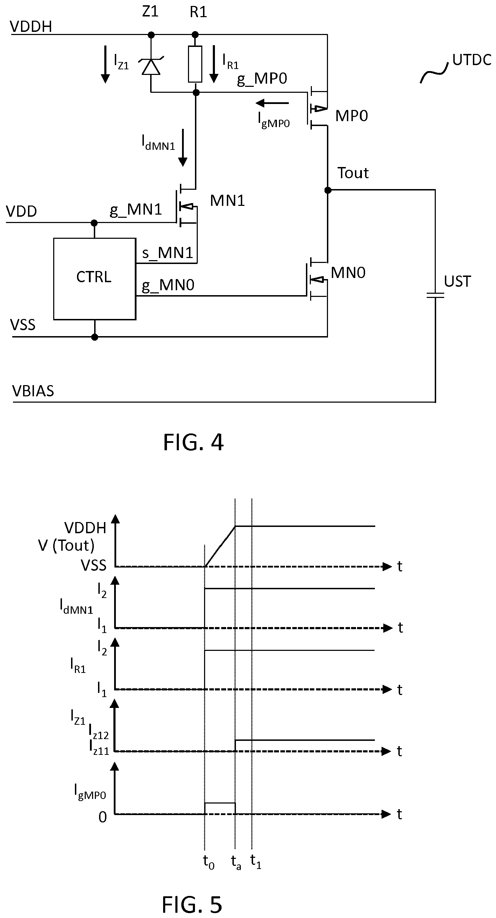

According to the first embodiment, pullup component R1 comprises a voltage-limiting component or circuit. Thereto, Fig. 4 illustrates an ultrasound transducer driver circuit UTDC that includes a voltage-limiting component Z1 in the form of a Zener diode. In this example Zener diode Z1 has a breakdown voltage that is less than the gate-source breakdown voltage of high-side transistor MP0, i.e. the p-channel FET MP0. In Fig. 4, Zener diode Z1 conducts a portion of the current provided by the first current source MN1 when said current has the second magnitude I₂ and thereby limits the gate-source voltage of the p-channel FET MP0 to less than a gate-source breakdown voltage of the p-channel FET MP0. In this case the voltage is limited to the breakdown voltage of the Zener diode.

In so doing the second magnitude I₂ of the current provided by first current source MN1 may be set to a higher value than would be possible in the absence of voltage-limiting component Z1. Current I₂ may thereby compensate for the opposing gate current I_{gMP0} of high-side transistor MP0 that flows in pullup component R1 during a positive voltage transition at output terminal Tout. Thus, high-side transistor MP0 may be switched-on harder, providing a faster positive voltage transition at output terminal Tout. At the end of the voltage transition, any of second magnitude current I₂ that would otherwise (i.e. in the absence of the voltage-limiting component Z1) have risked damaging high-side transistor MP0 due to it generating a gate-source potential difference that exceeds the breakdown voltage of high-side transistor MP0, is safely bypassed via voltage limiting component Z1, the Zener diode in Fig. 4, as current Izi. Thus, voltage limiting component Z1, the Zener diode in Fig. 4, limits the gate-source voltage of high-side transistor MP0 to less than the gate-source breakdown voltage of high-side transistor MP0 during a positive voltage transition at output terminal Tout.

In one example, the second magnitude I₂ of the current generated by first current source MN1 may be set to a value such that the product of the second magnitude I₂ and a resistance of the pullup component R1, i.e. I₂ × R1, exceeds the voltage limit of Zener diode Z1, or likewise the voltage limit of another voltage limiting component or circuit in its place. In so doing, Zener diode Z1 conducts a portion of the current provided by the first current source MN1 when said current has the second magnitude I₂.

In another example, the second magnitude I₂ of the current generated by first current source MN1 may be set to a value such that the product of the second magnitude I₂ and a resistance of the pullup component R1, i.e. I₂ × R1, exceeds a gate-source breakdown voltage of high-side transistor MP0. In other words, the magnitude of the current that is provided by the first current source MN1 in Fig. 4 in order to switch the high-side transistor into the conducting state, I₂, may be set at a level such that, in the absence of the voltage-limiting component or circuit Z1, the resulting gate-source voltage of high-side transistor MP0, i.e. the p-channel FET would exceed its breakdown voltage.

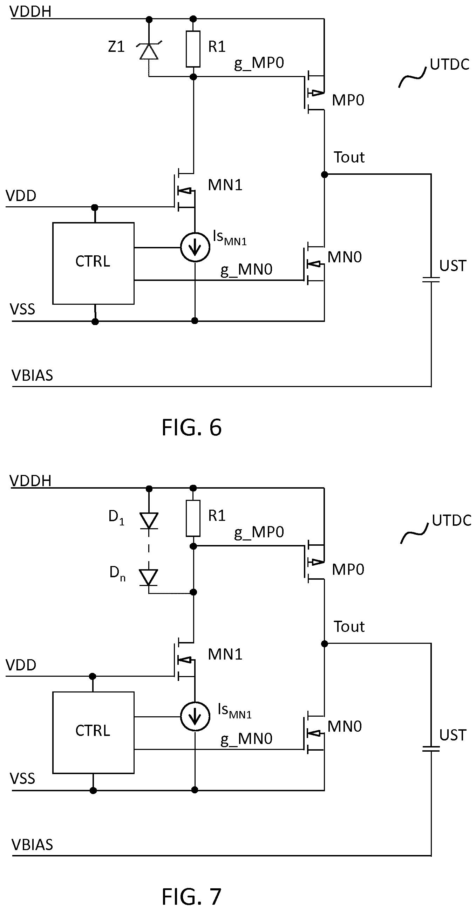

Other current sources to first current source MN1 illustrated in Fig. 4 are also contemplated for providing the desired current with the first magnitude I₁ and second magnitude I₂. An additional current source may for example be used to modulate the current provided by first current source MN1, as described later with reference to current source I_{SMN1} in Fig. 6. Other connections of first current source MN1 in Fig. 4 are also contemplated in this respect, including for example connecting source s_MN1 to power rail VSS and instead controlling the provision of current with the first magnitude I₁ and second magnitude I₂ by means of a voltage applied to gate g_MN1.

Operation of the circuit of Fig. 4 is illustrated in more detail with reference to Fig. 5, which illustrates various signals in the circuit of Fig. 4. In the circuit of Fig. 4, voltage-limiting component in the form of Zener diode Z1 is used to conduct a portion of the current provided by the first current source MN1 when the current provided by the first current source MN1 has the second magnitude I₂. Zener diode Z1 has a breakdown voltage that is less than a gate-source breakdown voltage of the p-channel FET MP0. With reference to Fig. 5, when current I_{dMN1} that is generated by first current source MN1 has the first value I₁, which is preferably a negligible value, i.e. at time 0 < t < t₀, pullup component R1 couples gate g_MP0 of high-side transistor, specifically p-channel FET MP0, to its source. The resulting gate-source voltage of p-channel FET MP0 is below its gate-source threshold voltage and thus high-side transistor MP0 is in the non-conducting state. Simultaneously, gate g_MN0 of low-side transistor MN0, specifically an n-channel FET, is held at a voltage such that an above-threshold gate-source voltage is applied to low-side transistor MN0 and low-side transistor MN0 is in the conducting state. Consequently the voltage at output terminal Tout, i.e. V(Tout) in Fig. 5, is held at the voltage of power rail VSS for time 0 < t < to. In order to generate a positive output pulse at terminal Tout, current I_{dMN1} that is provided by first current source MN1 is increased to value I₂ at time t = t₀ such that I₂ × R1 > V_{thresholdMP0} wherein V_{thresholdMP0} is the absolute value of the gate-source threshold voltage of high-side transistor MP0, and simultaneously the gate g_MN0 of low-side transistor MN0 is held at a voltage such that a sub-threshold gate-source voltage is applied to low-side transistor MN0 and low-side transistor MN0 is in the non-conducting state. When the voltage at output terminal Tout, i.e. V(Tout), starts to increase, i.e. for to < t < t₁ in Fig. 3, the high-side transistor's parasitic drain-gate capacitance couples charge between output terminal Tout and gate g_MP0. This coupled charge is represented by gate current I_{gMP0} that flows via pullup component R1 to power rail VDDH. Gate current I_{gMP0} opposes current I_{R1} in pullup component R1. As compared to the circuit of Fig. 1, the ability to provide a higher value of the second magnitude I₂ of the current with first current source MN1 allows for the compensation of gate current I_{gMP0} in pullup component R1 without risk of damaging high-side transistor MP0. The current provided by current source MN1 can therefore be increased, e.g. by an amount equal to the maximum gate current I_{gMP0}, which thus increases the switching speed of a positive voltage transition at output terminal Tout. At the end of the positive voltage transition at output terminal Tout, i.e. at t > tₐ in Fig 5, gate current I_{gMP0} becomes negligible and any current that exceeds the limit set by Zener diode Z1, is bypassed by Zener diode Z1, which thus restricts the gate-source voltage of high-side transistor MP0 to below its gate-source breakdown voltage.

Fig. 6 - Fig. 9 illustrate alternative ultrasound transducer driver circuits to the example of Fig. 4, and also implement the principles of the first embodiment. Thereto, Fig. 6 illustrates an ultrasound transducer driver circuit UTDC that includes a voltage-limiting component Z1 and an optional second current source I_{SMN1}. The circuit of Fig. 6 corresponds to the circuit of Fig. 4 wherein the voltage-limiting component is a Zener diode, and also includes second current source I_{SMN1}. Second current source I_{SMN1} is coupled in series with first current source MN1 and maybe provided for example by one or more transistors, i.e. FET(s) or bipolar transistor(s), using known circuits. Second current source I_{SMN1} may for instance include one or more series-coupled n-channel enhancement FETs that are operated in the so-called saturation region. By suitably controlling a gate-source voltage of each FET, the current generated by the FET(s) may be controlled. Alternatively, second current source I_{SMN1} may include one or more npn bipolar transistors. Preferably low-voltage npn bipolar transistor(s) are used, a low-voltage bipolar transistor being defined herein as having a collector-emitter breakdown voltage that is less than or equal to its base-emitter breakdown voltage; this being in contrast to a high-voltage bipolar transistor, defined herein as having a collector-emitter breakdown voltage exceeding its base-emitter breakdown voltage.

As illustrated in Fig. 6, second current source I_{SMN1} is coupled in series with first current source MN1. By coupling second current source I_{SMN1} in series with first current source MN1, second current source may be used to modulate the current provided by first current source MN1. The use of one or more transistors in this series-connected manner also allows them to share the total voltage that is switched, permitting them to be provided by one or more so-called low-voltage transistors. Thus, for example, first current source MN1 may include a high-voltage transistor and second current source I_{SMN1} may include one or more low-voltage transistors. This allows for simpler control of first current source MN1 because only low voltages are needed to control it. This may for instance permit control circuit CTRL to be provided with only low-voltage transistors.

Fig. 7 illustrates an ultrasound transducer driver circuit UTDC that includes voltage-limiting component(s) D₁..Dₙ and an optional second current source I_{SMN1}. Fig. 7 differs from Fig. 6 in that in place of Zener diode Z1 in Fig. 6, one or more diodes D₁..Dₙ serve in Fig. 7 as a voltage limiting component(s) to conduct a portion of the current provided by the first current source MN1 when said current has the second magnitude I₂ and thereby limit the gate-source voltage of the p-channel FET MP0 to less than a gate-source breakdown voltage of the p-channel FET MP0. Fig. 7 operates in a similar manner to that described in relation to Fig. 6 and thus also implements the principles of the first embodiment. The one or more diodes D₁..Dₙ in Fig. 7 are arranged to provide a combined voltage limit at which conduction occurs that is less than the gate-source breakdown voltage of high-side transistor MP0. Diode(s) D₁..Dₙ thus also bypass a portion of the current provided by first current source MN1 when said current has the second magnitude I₂.

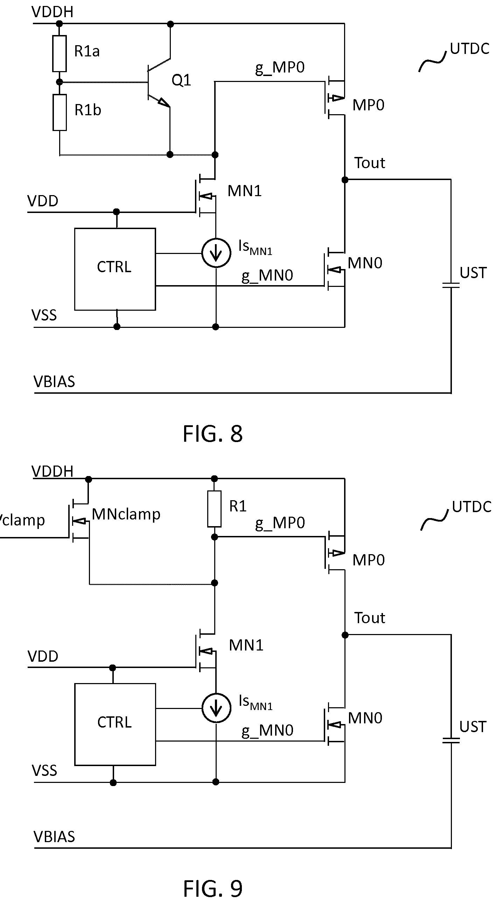

Fig. 8 illustrates an ultrasound transducer driver circuit UTDC that includes a voltage-limiting circuit Q1, R1a, R1b and an optional second current source I_{SMN1}. Fig. 8 differs from Fig. 6 in that in place of Zener diode Z1 in Fig. 6, a voltage-limiting circuit Q1, R1a, R1b is used in Fig. 8 to conduct a portion of the current provided by the first current source MN1 when said current has the second magnitude I₂ and thereby limit the gate-source voltage of the p-channel FET MP0 to less than a gate-source breakdown voltage of the p-channel FET MP0. Fig. 8 operates in a similar manner to that described in relation to Fig. 6 and thus also implements the principles of the first embodiment. The voltage-limiting circuit Q1, R1a, R1b in Fig. 8 conducts at a voltage limit that is less than the gate-source or base-emitter breakdown voltage of high-side transistor MP0. The voltage-limiting circuit Q1, R1a, R1 thus also bypasses a portion of the current provided by first current source MN1 when said current has the second magnitude I₂.

Fig. 9 illustrates an ultrasound transducer driver circuit UTDC that includes a voltage-limiting component MNclamp and an optional second current source I_{SMN1}. Fig. 9 differs from Fig. 6 in that in place of Zener diode Z1 in Fig. 6, a voltage-limiting component MNclamp is used in Fig. 9 to conduct a portion of the current provided by the first current source MN1 when said current has the second magnitude I₂ and thereby limit the gate-source voltage of the p-channel FET MP0 to less than a gate-source breakdown voltage of the p-channel FET MP0. Fig. 9 operates in a similar manner to that described in relation to Fig. 6 and thus also implements the principles of the first embodiment. Whilst other transistor implementations may alternatively be used, the voltage-limiting component MNclamp in Fig. 9 is an n-channel enhancement FET with a gate connected to a predetermined voltage, Vclamp, which determines the voltage limit at which conduction occurs. Preferably a low-voltage n-channel enhancement FET is used as voltage-limiting component MNclamp in Fig. 9. Voltage-limiting component MNclamp in Fig. 9 conducts so as to provide a voltage limit that is less than the gate-source breakdown voltage of high-side transistor MP0. The voltage-limiting component MNclamp thus also bypasses a portion of the current provided by first current source MN1 when said current has the second magnitude I₂.

The aforementioned drawback of a slow positive voltage transition at the output terminal of a half-bridge output stage circuit driven by level shifter that includes a current source and a pullup component, is also addressed in accordance with the principles of a second embodiment. In the second embodiment, which is described with reference to Fig. 1, an ultrasound transducer driver circuit UTDC comprises a half-bridge output stage and a level-shifter MN1, R1. The half-bridge output stage comprises a high-side transistor MP0, a low-side transistor MN0, and an output terminal Tout for driving an ultrasound transducer UST. The high-side transistor MP0 comprises a p-channel FET and the low-side transistor MN0 comprises an n-channel FET. The level-shifter MN1, R1 comprises a first current source MN1 and a pullup component R1 configured to modulate a voltage applied to a control input g_MP0 of the high-side transistor MP0 by alternately switching a current provided by the first current source MN1 between a first magnitude I₁ and a second magnitude I₂ such that a potential difference generated across the pullup component R1 causes the high-side transistor MP0 to be switched respectively between a non-conducting state and a conducting state by controlling a gate-source voltage of the p-channel FET MP0. The first current source MN1 is further configured to reduce the current from the second magnitude to a third magnitude I₃ after the high-side transistor MP0 is switched into the conducting state for maintaining the high-side transistor MP0 in the conducting state and ensuring the potential difference generated across the pullup component R1 is less than a gate-source breakdown voltage of the p-channel FET MP0.

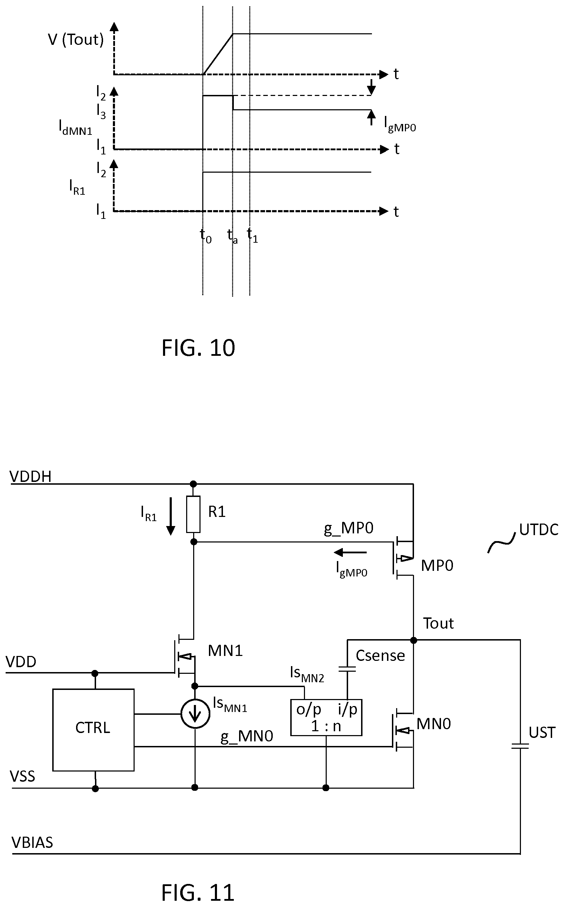

Operation of the second embodiment is detailed in Fig. 10, which illustrates various timing signals that may be used in accordance with a second embodiment in the circuit of Fig. 1 or Figs. 6 - 9. With reference to Fig. 10 and Fig. 1, first current source MN1 is controlled, for example by means of a control voltage applied to source s_MN1 of first current source MN1, and optionally via control circuit CTRL, to provide a current at each of three magnitude: a first magnitude I₁, a second magnitude I₂ and a third magnitude I₃. As illustrated in Fig. 10, the first magnitude is preferably zero or negligible current. The second magnitude I₂ exceeds the first magnitude I₁, and the third magnitude I₃ is between the first magnitude I₁ and the second magnitude I₂.. Other connections of first current source MN1 in Fig. 1 are also contemplated in this respect, including for example connecting source s_MN1 to power rail VSS and instead controlling the provision of current by means of a voltage applied to gate g_MN1. In operation, the control voltage applied to source s_MN1 of first current source MN1 in Fig. 1 generates each current magnitude.

With reference to Fig. 1, in operation, for time t < t₀ in Fig. 10, first current source MN1 provides a current with the first magnitude I₁, which is preferably zero or negligible, and pullup component R1 couples gate g_MP0 of high-side transistor MP0 to power rail VDDH. There is negligible potential difference generated across the pullup component R1, and thus high-side transistor MP0 is in the non-conducting state. During time t₀ < t < tₐ in Fig. 10, first current source MN1 provides a current with the second magnitude I₂. Second magnitude I₂ results in a potential difference being generated across pullup component R1 that exceeds the gate-source threshold voltage of high-side transistor MP0, and thus high-side transistor MP0 is in the conducting state. During this period, second magnitude I₂ may be set to a value that compensates for a change in voltage, specifically a reduction of said voltage, at the control input g_MP0 during a switching transition at output terminal Tout whilst high-side transistor MP0 is switched between the non-conducting state and the conducting state. The value of this current may be determined empirically or by circuit modelling.

In one example, second magnitude I₂ may be set to a value such that the product of the second magnitude I₂ and a resistance of the pullup component R1, i.e. I₂ × R1, exceeds a gate-source breakdown voltage of high-side transistor MP0.

Thus current I₂ operates to over-drive high-side transistor MP0 during a switching transition at output terminal Tout whilst high-side transistor MP0 is switched between the non-conducting state and the conducting state, and thereby provides a fast switching transition.

At the end of the positive switching transition at output terminal Tout, i.e. during time t > tₐ in Fig. 10, first current source MN1 reduces the current from second magnitude I₂ to third magnitude I₃. Third magnitude I₃ maintains high-side transistor MP0 in the conducting state and also ensures that the potential difference generated across the pullup component R1 is less than a gate-source breakdown voltage of the p-channel FET MP0. In so doing the switching speed at output terminal Tout may be increased whilst it undergoes a positive voltage transition, and damage to high-side transistor MP0 may be prevented after the voltage transition. The third magnitude I₃ may thus satisfy the condition I₃ × R1 is less than the gate-source breakdown voltage of high-side transistor MP0. In other words, third magnitude I₃ does not risk damaging high-side transistor MP0. In order to further prevent risk of damage to the circuit of Fig. 1, pullup component R1 in Fig. 1 may additionally include a voltage-limiting component or circuit Z1, D₁..Dₙ, Q1, R1a, R1b, MNclamp as illustrated in Figs. 6 - 9. Thus, in accordance with the second embodiment, pullup component R1 in Fig. 1 may include a voltage-limiting component or circuit Z1, D₁..Dₙ, Q1, R1a, R1b, MNclamp configured to conduct a portion of the current provided by the first current source MN1 when said current has the second magnitude I₂ and thereby limit the gate-source voltage of the p-channel FET MP0 to less than a gate-source breakdown voltage of the p-channel FET MP0. If such a voltage-limiting component or circuit is used, current magnitude I₃ may optionally no longer be used, such that during time t > tₐ in Fig. 10, first current source MN1 may instead continue to provide the current with the second magnitude I₂ as illustrated by the dashed line in Fig. 10. Any portion of second magnitude current I₂ that risks damage to high-side transistor MP0 during this period will be conducted by the voltage-limiting component.

The aforementioned drawback of a slow positive voltage transition at the output terminal of a half-bridge output stage circuit driven by level shifter that includes a current source and a pullup component, is also addressed in accordance with the principles of a third embodiment. In the third embodiment, which is described with reference to Fig. 11, an ultrasound transducer driver circuit UTDC includes a half-bridge output stage and a level-shifter. The half-bridge output stage comprises a high-side transistor MP0, a low-side transistor MN0, and an output terminal Tout for driving an ultrasound transducer UST. The high-side transistor MP0 comprises a p-channel FET and the low-side transistor MN0 comprises an n-channel FET. The level-shifter comprises a first current source MN1 and a pullup component R1 configured to modulate a voltage applied to a control input g_MP0 of the high-side transistor MP0 by alternately switching a current provided by the first current source MN1 between a first magnitude I₁ and a second magnitude I₂ such that a potential difference generated across the pullup component R1 causes the high-side transistor MP0 to be switched respectively between a non-conducting state and a conducting state by controlling a gate-source voltage of the p-channel FET MP0. The level-shifter further comprises a compensation current source I_{sMN2} configured to adjust the potential difference generated across the pullup component R1 during a switching transition at the output terminal Tout whilst the high-side transistor MP0 is switched between the non-conducting state and the conducting state for compensating for a change in voltage at the control input g_MP0 during said switching transition.

Fig. 11 corresponds to Fig. 1 and also includes compensation current source I_{sMN2} and sense capacitor Csense, and optional second current source I_{SMN1}. First current source MN1 in Fig. 11 provides the current with the first magnitude I₁ and the second magnitude I₂ in the same manner as described in relation to the first embodiment. In so doing, first current source MN1 switches high-side transistor MP0 between the non-conducting state and the conducting state. Compensation current source I_{sMN2} is coupled in series with first current source MN1. Compensation current source I_{sMN2} in Fig. 11 is implemented as an n:1 current mirror, and together with sense capacitor Csense operates in a feed-forward configuration to maintain control input g_MP0 of high-side transistor MP0 at a desired voltage when high-side transistor MP0 is switched into the conducting state. In operation, during a positive voltage transition at output terminal Tout, a current detected at the input i/p to n:1 current mirror I_{sMN2} via sense capacitor Csense is converted into 1/n^{th} of the detected current at output o/p of n:1 current mirror I_{sMN2} and increases the current provided by first current source MN1 by this amount. This positive feedback, between the positive voltage transition at output terminal Tout and the current provided by first current source MN1 increases the gate-source voltage of high-side transistor MP0, thereby compensating for the effect of the gate current I_{gMP0} on the gate-source voltage of high-side transistor MP0. In so doing, compensation current source I_{sMN2} adjusts the potential difference generated across pullup component R1 during a switching transition at the output terminal whilst the high-side transistor is switched between the non-conducting state and the conducting state and compensates for a change in voltage at the control input g_MP0 during said switching transition. The switching speed at output terminal Tout is thereby increased whilst it undergoes a positive voltage transition.

The circuit of Fig. 11 may also include optional second current source Is_{MN1}, which in Fig. 11 is entirely optional. In the absence of the second current source Is_{MN1} first current source MN1 may be connected as illustrated in Fig. 1. Possible implementations of second current source Is_{MN1} are described above in relation to Fig. 6. When second current source Is_{MN1} is present, this may, as illustrated in Fig. 11, be coupled in series with first current source MN1 and in parallel with compensation current source Is_{MN2}. Owing to the series connection with first current source MN1 the second current source Is_{MN1} modulates the current provided by the first current source MN1. The second current source Is_{MN1} may for example be controlled by control circuit CTRL to modulate the current provided by the first current source MN1 between the first magnitude I₁ and the second magnitude I₂.

Any of the circuits described herein may be controlled by optional control circuit CTRL as illustrated in the Figures. In this sense, control circuit CRTL may include hardware or software or a processor or a combination thereof configured to cause the current provided by the first current source MN1 to be switched between the first magnitude I₁ and the second magnitude I₂ for switching the high-side transistor MP0 respectively between the non-conducting state and the conducting state. Control circuit CTRL may likewise control a control input g_MN0 of low-side transistor MN0. Control circuit CTRL may thus be coupled to a control input of first current source MN1 and/ or to a control input of the second current source Is_{MN1}, as well as to a control input of g_MN0 of low-side transistor MN0. Control circuit CRTL may alternately switch each of low-side transistor MN0 and high-side transistor MP0 into each of the non-conducting state and the conducting state such that they are in opposite states.

Optionally, control circuit CRTL may implement a break-before-make switching operation wherein low-side transistor MN0 is switched into the non-conducting state before high-side transistor MP0 is switched into the conducting state, and wherein high-side transistor MP0 is switched into the non-conducting state before low-side transistor MN0 is switched into the conducting state.

Any of the circuits described herein may be coupled to an ultrasound transducer UST as illustrated in the Figures. The use of the circuits with CMUT, or PMUT and other ultrasound transducers is contemplated.

Moreover, any of the ultrasound transducer driver circuits described herein may be incorporated into an application specific integrated circuit, i.e. ASIC.

Any of the ultrasound transducer driver circuits described herein, or the ASIC, may be incorporated into an ultrasound sensing system or an ultrasound imaging system, which may be 2D or 3D, and which may without limitation, be an IVUS imaging system, a "TEE" transesophageal, a "TTE" transthoracic, a "TNE" transnasal, an "ICE" intracardiac, or a "TRUS" transrectal ultrasound imaging system. Use of the ultrasound transducer driver circuits or the ASIC is contemplated in both invasive, i.e. internal and external imaging probes, as well as in 2D and 3D ultrasound imaging systems.

In summary, an ultrasound transducer driver circuit UTDC has been provided which includes a half-bridge output stage and a level-shifter. The half-bridge output stage includes a high-side transistor MP0, a low-side transistor MN0. The high-side transistor MP0 comprises a p-channel FET and the low-side transistor MN0 comprises an n-channel FET. A pullup component R1 of the level shifter comprises a voltage-limiting component or circuit Z1, D₁..Dₙ, Q1, R1a, R1b, MNclamp that conducts a portion of the current provided by a first current source MN1 of the level shifter to limit the gate-source voltage of the p-channel FET MP0 to less than a gate-source breakdown voltage of the p-channel FET MP0.

Various options have been described in relation to the ultrasound transducer driver circuits, and it is noted that the various embodiments may be combined to achieve further advantageous effects. Any reference signs in the claims should not be construed as limiting the scope of the invention.

## Claims

1. Ultrasound transducer driver circuit (UTDC) comprising:
a half-bridge output stage comprising a high-side transistor (MPO), a low-side transistor (MN0), and an output terminal (Tout) for driving an ultrasound transducer (UST); and
a level-shifter (MN1, R1);
wherein the high-side transistor (MPO) comprises a p-channel FET and the low-side transistor (MN0) comprises an n-channel FET;
wherein the level-shifter (MN1, R1) comprises a first current source (MN1) and a pullup component (R1) configured to modulate a voltage applied to a control input (g_MP0) of the high-side transistor (MPO) by alternately switching a current provided by the first current source (MN1) between a first magnitude (I₁) and a second magnitude (I₂) such that a potential difference generated across the pullup component (R1) causes the high-side transistor (MPO) to be switched respectively between a non-conducting state and a conducting state by controlling a gate-source voltage of the p-channel FET (MPO);
wherein the pullup component (R1) comprises a voltage-limiting component or circuit (Z1, D₁..Dₙ, Q1, R1a, R1b, MNclamp) configured to conduct a portion of the current provided by the first current source (MN1) when said current has the second magnitude (I₂) and thereby limit the gate-source voltage of the p-channel FET (MPO) to less than a gate-source breakdown voltage of the p-channel FET (MP0).

2. Ultrasound transducer driver circuit (UTDC) according to claim 1 wherein the high-side transistor (MPO) comprises a high-voltage p-channel FET and the low-side transistor (MN0) comprises a high-voltage n-channel FET and/ or the first current source (MN1) comprises a high-voltage n-channel FET.

3. Ultrasound transducer driver circuit (UTDC) according to claim 1 or claim 2 further comprising a second current source (Is_{MN1});
wherein the second current source (Is_{MN1}) is coupled in series with the first current source (MN1) and is configured to modulate the current provided by the first current source (MN1) between the first magnitude (I₁) and the second magnitude (I₂).

4. Ultrasound transducer driver circuit (UTDC) according to claim 3, and wherein the second current source (Is_{MN1}) comprises i) at least one n-channel FET, or ii) at least one npn bipolar transistor.

5. Ultrasound transducer driver circuit (UTDC) according to claim 4 wherein i) the at least one n-channel FET comprises a low-voltage FET, or ii) the at least one npn bipolar transistor comprises a low-voltage npn bipolar transistor.

6. Ultrasound transducer driver circuit (UTDC) comprising:
a half-bridge output stage comprising a high-side transistor (MPO), a low-side transistor (MN0), and an output terminal (Tout) for driving an ultrasound transducer (UST); and
a level-shifter (MN1, R1);
wherein the high-side transistor (MP0) comprises a p-channel FET and the low-side transistor (MN0) comprises an n-channel FET;
wherein the level-shifter (MN1, R1) comprises a first current source (MN1) and a pullup component (R1) configured to modulate a voltage applied to a control input (g_MP0) of the high-side transistor (MP0) by alternately switching a current provided by the first current source (MN1) between a first magnitude (I₁) and a second magnitude (I₂) such that a potential difference generated across the pullup component (R1) causes the high-side transistor (MPO) to be switched respectively between a non-conducting state and a conducting state by controlling a gate-source voltage of the p-channel FET (MPO);
wherein the first current source (MN1) is further configured to reduce the current from the second magnitude to a third magnitude (I₃) after the high-side transistor (MPO) is switched into the conducting state for maintaining the high-side transistor (MPO) in the conducting state and ensuring the potential difference generated across the pullup component (R1) is less than a gate-source breakdown voltage of the p-channel FET (MP0).

7. Ultrasound transducer driver circuit (UTDC) according to claim 6 further comprising a second current source (Is_{MN1});
wherein the second current source (Is_{MN1}) is coupled in series with the first current source (MN1) and is configured to modulate the current provided by the first current source (MN1) between the first magnitude (I₁) and the second magnitude (I₂).

8. Ultrasound transducer driver circuit (UTDC) comprising:
a half-bridge output stage comprising a high-side transistor (MPO), a low-side transistor (MN0), and an output terminal (Tout) for driving an ultrasound transducer (UST); and
a level-shifter (MN1, R1);
wherein the high-side transistor (MP0) comprises a p-channel FET and the low-side transistor (MN0) comprises an n-channel FET;
wherein the level-shifter (MN1, R1) comprises a first current source (MN1) and a pullup component (R1) configured to modulate a voltage applied to a control input (g_MP0) of the high-side transistor (MP0) by alternately switching a current provided by the first current source (MN1) between a first magnitude (I₁) and a second magnitude (I₂) such that a potential difference generated across the pullup component (R1) causes the high-side transistor (MP0) to be switched respectively between a non-conducting state and a conducting state by controlling a gate-source voltage of the p-channel FET (MPO); and wherein the level-shifter further comprises a compensation current source (Is_{MN2}) configured to adjust the potential difference generated across the pullup component (R1) during a switching transition at the output terminal (Tout) whilst the high-side transistor (MPO) is switched between the non-conducting state and the conducting state for compensating for a change in voltage at the control input (g_MP0) during said switching transition.

9. Ultrasound transducer driver circuit according to claim 8 wherein the compensation current source (Is_{MN2}) is coupled in series with the first current source (MN1); and further comprises a sense capacitor (Csense) and a feed-forward circuit configured to sense the switching transition at the output terminal (Tout) and in response to said switching transition to control a current provided by the compensation current source (Is_{MN2}) and to thereby control the potential difference generated across the pullup component (R1) for compensating for the change in voltage at the control input (g_MP0) during said switching transition.

10. Ultrasound transducer driver circuit (UTDC) according to claim 9 further comprising a second current source (Is_{MN1});
wherein the second current source (Is_{MN1}) is coupled in series with the first current source (MN1) and in parallel with the compensation current source (Is_{MN2});
and wherein the second current source (Is_{MN1}) and is configured to modulate the current provided by the first current source (MN1) between the first magnitude (I₁) and the second magnitude (I₂).

11. Ultrasound transducer driver circuit according to any one of claims 1 - 10 further comprising a control circuit (CRTL);
wherein the control circuit (CRTL) is configured to cause the current provided by the first current source (MN1) to be switched between the first magnitude (I₁) and the second magnitude (I₂) for switching the high-side transistor (MPO) respectively between the non-conducting state and the conducting state; and
wherein the control circuit (CRTL) is further configured to control a control input (g_MN0) of the low-side transistor (MN0);
and wherein the control circuit (CRTL) is further configured to alternately switch each of the low-side transistor (MN0) and the high-side transistor (MPO) into each of the non-conducting state and the conducting state such that the low-side transistor (MN0) and the high-side transistor (MP0) are in opposite states.

12. Ultrasound transducer driver circuit (UTDC) according to any one of claims 1 - 11 wherein a high-voltage FET comprises a FET having a drain-source breakdown voltage that exceeds a gate-source breakdown voltage of the FET, and wherein a low-voltage FET comprises a FET having a drain-source breakdown voltage that is less than or equal to a gate-source breakdown voltage of the FET.

13. Ultrasound transducer driver circuit (UTDC) according to any one of claims 1 - 12 further comprising an ultrasound transducer (UST), and wherein the ultrasound transducer (UST) is coupled to the output terminal (Tout).

14. Application specific integrated circuit comprising the ultrasound transducer driver circuit according to any one of claims 1 - 12.

15. Ultrasound imaging system comprising the ultrasound transducer driver circuit according to any one of claims 1 - 13, or the application specific integrated circuit according to claim 14.
